# EUROPÄISCHE PATENTSCHRIFT

(11) **EP 1 595 293 B1**
(45) Veröffentlichungstag und Bekanntmachung des Hinweises auf die Patenterteilung: **20.06.2007**
(21) Anmeldenummer: 04818417.0
(22) Anmeldetag: 10.11.2004
(51) Int. Cl.: H01L 41/083, H01L 41/047, F02M 51/06

(54) **KONTAKTIERUNG FÜR EINEN AKTOR UND ZUGEHÖRIGES HERSTELLUNGSVERFAHREN**
CONTACTING DEVICE FOR AN ACTUATOR, AND ASSOCIATED PRODUCTION METHOD
DISPOSITIF DE MISE EN CONTACT POUR ACTIONNEUR, ET PROCEDE DE PRODUCTION CORRESPONDANT

(30) Priorität: 12.11.2003 DE 10352773
(43) Veröffentlichungstag der Anmeldung: 16.11.2005
(73) Patentinhaber: SIEMENS AKTIENGESELLSCHAFT, 80333 München (DE)
(72) Erfinder: DÖLLGAST, Bernd, 91054 Erlangen (DE); SCHRÖDER, Martin, 93093 Donaustauf (DE)
(86) Internationale Anmeldenummer: PCT/EP2004/052901
(87) Internationale Veröffentlichungsnummer: WO 2005/048365

(56) Entgegenhaltungen:
- WO-A-96/07185
- WO-A-20/04004021
- DE-A1- 10 026 635
- DE-A1- 19 917 728
- DE-B1- 1 942 784
- PATENT ABSTRACTS OF JAPAN Bd. 2000, Nr. 25, 12. April 2001 (2001-04-12) -& JP 2001 210884 A (KYOCERA CORP), 3. August 2001 (2001-08-03)

## Beschreibung

Die Erfindung betrifft einen Piezoaktor, insbesondere zum Antrieb eines Injektors einer Einspritzanlage, gemäß dem Oberbegriff des Anspruchs 1 sowie ein Herstellungsverfahren eines Piezoaktors gemäß dem Oberbegriff von Anspruch 8.

Moderne Einspritzanlagen für Brennkraftmaschinen weisen zur mechanischen Ansteuerung der Injektoren zunehmend Piezoaktoren auf, die im Vergleich zu herkömmlichen elektromagnetischen Aktoren ein besseres dynamisches Verhalten aufweisen. Derartige Piezoaktoren haben herkömmlicherweise einen Piezostapel, in dem eine Vielzahl von schichtförmigen Piezoelementen übereinander angeordnet sind, wobei sich zwischen den einzelnen Piezoelementen jeweils schichtförmige Elektroden befinden. Die elektrische Kontaktierung des Piezostapels erfolgt durch Metallisierungsstreifen, die auf gegenüberliegenden Seitenflächen des Piezostapels angeordnet sind und über die gesamte Länge des Piezostapels reichen, wobei die einzelnen schichtförmigen Elektroden des Piezostapels abwechselnd mit einem der beiden Metallisierungsstreifen verbunden sind. Die beiden Metallisierungsstreifen sind wiederum mit zwei Anschlussstiften verbunden, die auf gegenüberliegenden Seiten des Piezostapels angeordnet sind und stirnseitig aus dem Piezoaktor herausragen, um an der Außenseite eine elektrische Kontaktierung zu ermöglichen. Aus DE 100 26 635 A1 ist es bekannt, zur elektrischen Verbindung der Metallisierungsstreifen des Piezostapels mit den zugehörigen Anschlussstiften eine Kontaktierungsmatte in Form eines Drahtgeflechts zu verwenden, wobei die Kontaktierungsmatte sogenannte Schussfäden und Kettfäden aufweist. Die Schussfäden sind hierbei parallel zueinander angeordnet, bestehen aus einem leitfähigen Material und verbinden die Metallisierungsstreifen des Piezostapels mit dem jeweils zugehörigen Anschlussstift. Die sogenannten Kettfäden verlaufen dagegen innerhalb der Kontaktierungsmatte rechtwinklig zu den Schussfäden und verbinden diese untereinander, um die Schussfäden mechanisch zu stabilisieren.

Nachteilig an einem Piezoaktor mit einer bekannten Kontaktierungsmatte ist die Tatsache, dass es im Betrieb des Piezoaktors zu Brüchen und Rissen in der Kontaktierungsmatte kommen kann.

Aus der DE 199 17 728 A1 ist bekannt, die Kontaktierung eines Piezoaktors herzustellen, indem ein Draht auf ein Blechband bondiert, geschweißt oder gelötet wird und die Enden des Drahtes abgeschnitten werden. So wird eine Kontaktierungsmatte in Form einer Zusatzelektrode hergestellt. Zwei dieser Zusatzelektroden werden dann mit jeweils einem Metallisiierungsstreifen elektrisch verbunden. Nachteilig ist hier die aufwändige Fertigung des Piezoaktors und wiederum die Neigung zu Brüchen und Rissen in der Kontaktierungsmatte.

Der Erfindung liegt deshalb die Aufgabe zugrunde, ein Herstellungsverfahren für eine Kontaktierungsmatte anzugeben, das zu Kontaktierungsmatten für Piezoaktoren führt, und einen Piezoaktor anzugeben, so dass die Bruchwahrscheinlichkeit der Kontaktierungsmatten reduziert ist.

Diese Aufgabe wird erfindungsgemäß durch einen Piezoaktor nach Anspruch 1 und ein Herstellungsverfahen nach Anspruch 8 gelöst. Vorteilhafte Weiterbildungen finden sich in den Unteransprüchen.

Die Erfindung beruht auf der technischen Erkenntnis, dass die im Betrieb des Aktors auftretenden Risse innerhalb der Kontaktierungsmatte durch die Längenänderung des Piezostapels verursacht werden, wodurch die sogenannten Kettfäden mechanisch belastet werden.

Die Erfindung umfaßt deshalb die allgemeine technische Lehre, anstelle von unflexiblen Kettfäden aus Draht ein nachgiebiges Material (z.B. Silikon) zu verwenden, um die einzelnen Drähte der Kontaktierungsmatte miteinander zu verbinden. Durch die Nachgiebigkeit der Verbindung zwischen den einzelnen Drähten der Kontaktierungsmatte wird vorteilhaft verhindert, dass eine Längenänderung des Piezostapels im späteren Betrieb zu einer Beschädigung der Verbindung führt.

Vorzugsweise ist das nachgiebige Material elastisch und/oder schwingungsdämpfend, um eine Beschädigung im späteren Betrieb zu vermeiden. Es ist jedoch theoretisch auch möglich, dass das nachgiebige Material ein plastisches Verformungsverhalten aufweist. Entscheidend ist lediglich, dass das Material hinreichend nachgiebig ist, um im späteren Betrieb des Aktors die Längenänderung des Aktorkörpers auszugleichen.

In einem bevorzugten Ausführungsbeispiel der Erfindung sind die einzelnen Drähte der Kontaktierungsmatte in das nachgiebige Material eingehüllt, wozu die einzelnen Drähte beispielsweise mit dem nachgiebigen Material umgossen oder umspritzt werden können.

Vorteilhaft an der Verbindung der einzelnen Drähte nach dem erfindungsgemäßen Herstellungsverfahren zu einer Kontaktierungsmatte ist die gute Handhabbarkeit, da die Kontaktierungsmatte beispielsweise auf eine Vorratsrolle aufgewickelt werden kann, wobei die aufgewickelte Kontaktierungsmatte die Kontaktierung einer Vielzahl von Aktoren ermöglicht. Die Kontaktierungsmatte kann also in einem separaten Herstellungsverfahren vorgefertigt werden, was eine effiziente und kostengünstige Fertigung erlaubt.

Als Material zur Verbindung der einzelnen Drähte der Kontaktierungsmatte eignet sich besonders vorteilhaft Silikon oder ein anderes silikonhaltiges Material, da Silikon gute elastische Eigenschaften aufweist und ein gutes Dämpfungsverhalten zeigt.

Die Erfindung ist jedoch hinsichtlich des zu verwendenden Materials nicht auf Silikon beschränkt, sondern grundsätzlich auch mit anderen Materialien realisierbar, die ein geeignetes Verformungsverhalten aufweisen.

Vorteilhaft an einemerfindungsgemäßen Piezoaktor ist unter anderem die Tatsache, dass auf einen vollständigen, massiven Verguß des Aktors mit einer Vergussmasse (z.B. Silikon) verzichtet werden kann, da die einzelnen Drähte der Kontaktierungsmatte bereits durch das nachgiebige Material ausreichend gestützt werden.

Es ist jedoch auch bei dem erfindungsgemäßen Aktor grundsätzlich möglich, den Aktor in herkömmlicher Weise massiv und vollständig mit einer Vergussmasse (z.B. Silikon) zu vergießen. Bei einem derartigen vollständigen Vergießen des Aktors unterscheidet sich die Vergussmasse jedoch vorzugsweise hinsichtlich ihrer Materialeigenschaften von dem nachgiebigen Material, das die einzelnen Drähte der Kontaktierungsmatte miteinander verbindet. So sollte das nachgiebige Material zur Verbindung der einzelnen Drähte der Kontaktierungsmatte vorzugsweise ein Benetzungs- und Fliessverhalten aufweisen, das es ermöglicht, das nachgiebige Material durch einen Tauchvorgang auf die Drähte der Kontaktierungsmatte aufzubringen, wobei das nachgiebige Material beim Verfestigen Verbindungsbrücken zwischen den einzelnen Drähten der Kontaktierungsmatte bildet. Im Gegensatz dazu sollte die Vergussmasse für das massive Vergießen des gesamten Aktors vorzugsweise ein Benetzungsund Fliessverhalten aufweisen, das auch eine Füllung kleiner Hohlräume innerhalb des Aktors sicherstellt.

Die Herstellung der erfindungsgemäßen Kontaktierungsmatte kann im Rahmen eines separaten Fertigungsverfahrens erfolgen, so dass die fertige Kontaktierungsmatte mit dem Aktorkörper und den zugehörigen Anschlussstiften verbunden werden kann.

Beispielsweise ist es möglich, dass der Aktorkörper zunächst über eine Vielzahl von parallel verlaufenden Drähten mit den zugehörigen Anschlussstiften verbunden wird, wobei die einzelnen Drähte zunächst noch nicht mechanisch miteinander verbunden sind. Anschließend kann dann die aus dem Aktorkörper und den beiden Anschlussstiften bestehende Aktoreinheit in das verflüssigte nachgiebige Material eingetaucht werden, wobei die einzelnen Drähte von dem nachgiebigen Material benetzt werden, so dass sich Verbindungsbrücken zwischen den einzelnen Drähten bilden und dadurch eine erfindungsgemäße Kontaktierungsmatte entsteht.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1:: eine Perspektivansicht eines Piezostapels mit zwei zugehörigen Anschlussstiften und einer Kontaktierungsmatte zur elektrischen Verbindung des Piezostapels mit den Anschlussstiften,
- Figur 2: eine Querschnittsansicht eines Teils der Kontaktierungsmatte aus Figur 1,
- Figur 3: eine schematische Darstellung einer Vorrichtung zur Durchführung des erfindungsgemäßen Herstellungsverfahrens sowie
- Figur 4: eine schematische Querschnittsansicht des Piezostapels mit den Anschlussstiften und der Kontaktierungsmatte aus Figur 3.

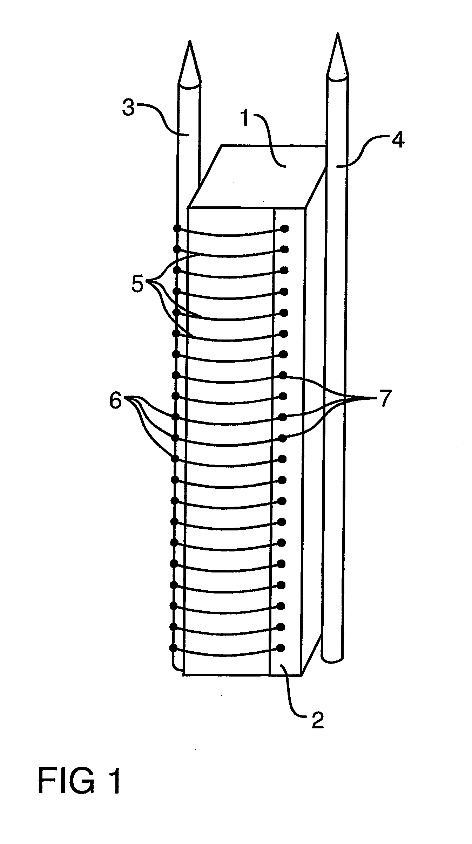

Die Querschnittsansicht in Figur 1 zeigt einen Piezostapel 1, der eine Vielzahl von übereinander angeordneten schichtförmigen Piezoelementen aufweist, wobei zwischen den einzelnen Piezoelementen jeweils eine Elektrodenschicht angeordnet ist.

Auf die in der Zeichnung sichtbare vordere Seitenfläche des Piezostapels 1 ist ein Metallisierungsstreifen 2 aufgebracht, der über die gesamte Länge des Piezostapels durchgeht.

Ein weiterer derartiger Metallisierungsstreifen ist auf die in der Zeichnung nicht sichtbare hintere Seitenfläche des Piezostapels 1 aufgebracht, wobei die einzelnen Elektrodenschichten des Piezostapels 1 abwechselnd mit dem Metallisierungsstreifen 2 und mit dem nicht sichtbaren hinteren Metallisierungsstreifen verbunden sind.

Die elektrische Kontaktierung erfolgt hierbei durch zwei Anschlussstifte 3, 4 die seitlich neben dem Piezostapel 1 angeordnet und parallel zueinander ausgerichtet sind.

Der Anschlussstift 3 ist über eine Vielzahl von elektrisch leitfähigen Drähten 5 mit dem Metallisierungsstreifen 2 verbunden, während der Anschlussstift 4 über verdeckte weitere Drähte mit dem an der Hinterseite des Piezostapels 1 angeordneten und nicht sichtbaren Metallisierungsstreifen verbunden ist.

Die einzelnen Drähte 5 sind hierbei jeweils durch Lötstellen 6, 7 mit dem Anschlussstift 3 und dem Metallisierungsstreifen 2 verbunden.

Vorteilhaft an der Verbindung des Metallisierungsstreifens 2 mit dem Anschlussstift 3 durch eine Vielzahl von Drähten 5 ist die Tatsache, dass die einzelnen Drähte 5 bei der im späteren Betrieb des Piezoaktors auftretenden Längenänderung des Piezostapels 1 individuell der Bewegung des Piezostapels 1 folgen können, wodurch die Gefahr einer Beschädigung der Drähte 5 herabgesetzt wird.

Zum anderen führt die Vielzahl der Drähte 5 zu einer erhöhten Betriebssicherheit, da auch bei einer Unterbrechung der durch einen der Drähte 5 hergestellten elektrischen Verbindung noch eine sichere Kontaktierung durch die anderen Drähte 5 gewährleistet ist.

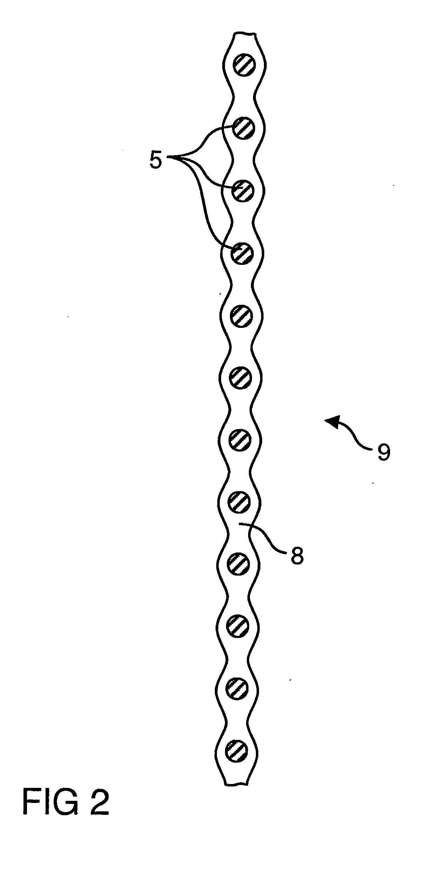

Aus zeichnungstechnischen Gründen sind die einzelnen Drähte 5 in Figur 1 einzeln dargestellt. Aus der Querschnittsansicht in Figur 2 ist jedoch ersichtlich, dass die einzelnen Drähte 5 in ein Material 8 eingebettet sind und eine Kontaktierungsmatte 9 bilden, wobei das Material 8 mechanische Verbindungsbrücken zwischen den einzelnen Drähten 5 bildet.

Bei dem Material 8 handelt es sich hierbei um Silikon, das ein elastisches und schwingungsdämpfendes Verformungsverhalten aufweist, so dass Längenänderungen des Piezostapels 1 im späteren Betrieb des Piezoaktors nicht zu einer Beschädigung der Drähte 5 oder der Lötstellen 6, 7 führen.

Die Umhüllung der Drähte 5 mit dem nachgiebigen Material 8 kann hierbei im Rahmen eines separaten Herstellungsverfahrens erfolgen, bevor die Kontaktierungsmatte 9 mit dem Piezostapel 1 und den Anschlussstiften 3, 4 verbunden wird. Hierzu können die einzelnen Drähte 5 beispielsweise in ein Tauchbad aus verflüssigtem Silikon eingetaucht werden, wobei die Oberflächen der Drähte 5 mit Silikon benetzt werden, so dass sich Verbindungsbrücken zwischen den einzelnen Drähten 5 ausbilden.

Es ist jedoch alternativ auch möglich, dass die einzelnen Drähte 5 einzeln mit dem Piezostapel 1 und den zugehörigen Anschlussstiften 3, 4 verbunden werden, wobei die Umhüllung der einzelnen Drähte und die Ausbildung der Kontaktierungsmatte 9 erst anschließend erfolgt, indem der Piezostapel 1 mit den Anschlussstiften 3, 4 und den damit verbundenen Drähten 5 in ein Tauchbad aus verflüssigtem Silikon eingetaucht wird, wobei die Drähte 5 dann mit dem Material 8 benetzt werden, so dass sich Verbindungsbrücken zwischen den einzelnen Drähten 5 ausbilden, was zur Formung der Kontaktierungsmatte 9 führt.

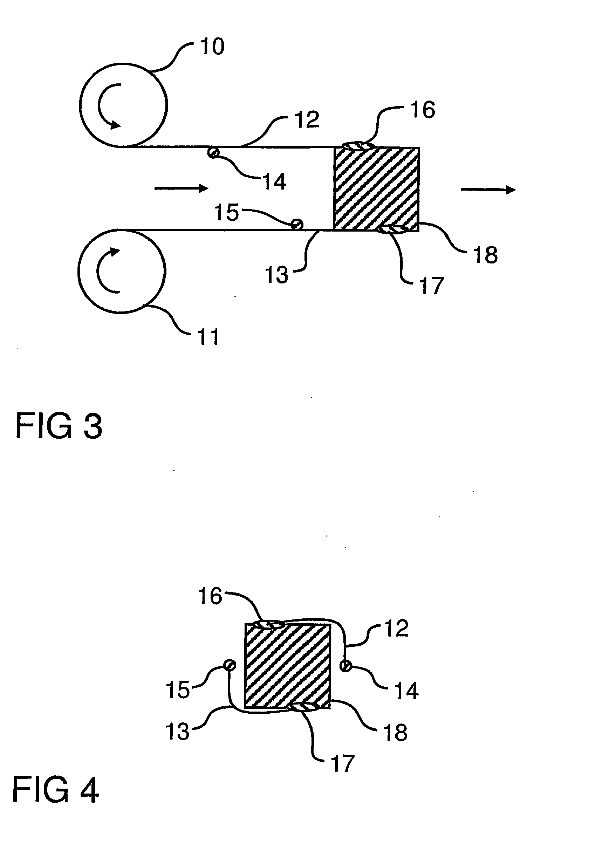

Figur 3 zeigt in stark vereinfachter Form eine Vorrichtung zur Herstellung von Piezoaktoren mit der erfindungsgemäßen Kontaktierungsmatte.

Hierzu weist die Vorrichtung zwei Vorratsrollen 10, 11 auf, auf die jeweils eine fertige Kontaktierungsmatte 12, 13 aufgewickelt ist.

Die Kontaktierungsmatten 12, 13 werden dann von den Vorratsrollen 10, 11 abgewickelt und auf zwei Anschlussstifte 14, 15 sowie auf die Metallisierungsstreifen 16, 17 eines Piezostapels 18 aufgebracht.

Anschließend wird die Kontaktierungsmatte 12 dann mit dem Anschlussstift 12 und mit dem Metallisierungsstreifen 16 verlötet und dann zwischen dem Anschlussstift 14 und der Vorratsrolle 10 getrennt.

In ähnlicher Weise wird die Kontaktierungsmatte 13 mit dem Anschlussstift 15 und dem Metallisierungsstreifen 17 verlötet und dann zwischen dem Anschlussstift 15 und der Vorratsrolle 11 getrennt.

In einem nächsten Arbeitsschritt wird die Kontaktierungsmatte 12 dann um den Piezostapel 18 in Uhrzeigerrichtung herum geschlagen, bis der Anschlussstift 14 die in Figur 4 gezeigte Endstellung einnimmt.

In ähnlicher Weise wird auch die Kontaktierungsmatte 13 in Uhrzeigerrichtung um den Piezostapel 18 herumgeschlagen, bis der Anschlussstift 15 die in Figur 4 gezeigte Endstellung einnimmt.

Schließlich kann die gesamte Piezoeinheit dann noch massiv vergossen werden, was bekannt ist und deshalb zur Vereinfachung nicht weiter beschrieben wird.

## Patentansprüche

1. Piezoaktor mit
- einem Aktorkörper (1, 18),
- zwei Anschlussstiften (3, 4, 14, 15) und
- einer Kontaktierung mit mehreren elektrisch leitfähigen und nebeneinander verlaufenden Drähten (5), die den Aktorkörper (1, 18) mit den Anschlussstiften (3, 4, 14, 15) verbinden,
wobei die einzelnen Drähte (5) mechanisch miteinander verbunden sind und eine Kontaktierungsmatte (9, 12, 13) bilden,
**dadurch gekennzeichnet, dass**
die mechanische Verbindung der einzelnen Drähte (5) durch ein nachgiebiges Material (8) gebildet ist, um im späteren Betrieb eine Beschädigung der Drähte (5) bei einer Längenänderung des Aktorkörpers (1, 18) zu verhindern.

2. Piezoaktor nach Anspruch 1, **dadurch gekennzeichnet, dass** das nachgiebige Material (8) elastisch und/oder schwingungsdämpfend ist.

3. Piezoaktor nach einem der vorhergehenden Ansprüche, **dadurch gekennzeichnet, dass** die einzelnen Drähte (5) in das nachgiebige Material (8) eingehüllt sind.

4. Piezoaktor nach einem der vorhergehenden Ansprüche, **dadurch gekennzeichnet, dass** die einzelnen Drähte (5) mit dem nachgiebigen Material (8) umgossen oder umspritzt sind.

5. Piezoaktor nach einem der vorhergehenden Ansprüche, **dadurch gekennzeichnet, dass** das nachgiebige Material (8) Silikon ist oder zumindest silikonhaltig ist.

6. Piezoaktor nach einem der vorhergehenden Ansprüche, **dadurch gekennzeichnet, dass** die Drähte (5) der Kontaktierungsmatte (9) wesentlich länger sind als der zu überbrückende Abstand zwischen dem Aktorkörper (1, 18) und dem zugehörigen Anschlussstift (3,4, 14,15).

7. Injektor für eine Einspritzanlage einer Brennkraftmaschine mit einem Piezoaktor nach einem der Ansprüche 1 bis 6.

8. Herstellungsverfahren eines Piezoaktors mit den Schritten:
- Anordnung mehrerer elektrisch leitfähiger Drähte (5) nebeneinander und
- mechanische Verbindung der einzelnen Drähte (5) miteinander zu einer Kontaktierungsmatte (9, 12, 13)
**dadurch gekennzeichnet, dass**
die mechanische Verbindung der einzelnen Drähte (5) untereinander durch ein nachgiebiges Material (8) hergestellt wird, indem die Drähte (5) vor einem etwaigen Verbinden mit einem Piezostapel, in das verflüssigte nachgiebige Material (8) eingetaucht werden, wobei das verflüssigte Material (8) die Drähte (5) benetzt und zwischen den Drähten (5) Verbindungsbrücken bildet,
- Verbindung der Kontaktierungsmatte (3, 4, 14, 15) mit dem Aktorkörper (1, 18) und den zugehörigen Anschlussstiften (3,4, 14,15).

9. Herstellungsverfahren nach Anspruch 8, **dadurch gekennzeichnet, dass** das nachgiebige Material (8) elastisch und/oder schwingungsdämpfend ist.

10. Herstellungsverfahren nach einem der Ansprüche 8 bis 9, **dadurch gekennzeichnet, dass** das nachgiebige Material (8) Silikon ist oder zumindest silikonhaltig ist.

11. Herstellungsverfahren nach einem der Ansprüche 8 bis 10, **gekennzeichnet durch** den zusätzlichen Schritt:
- Aufwickeln der Kontaktierungsmatte auf eine Vorratsrolle.

12. Herstellungsverfahren nach einem der Ansprüche 8 bis 11 mit dem zusätzlichen Schritt:
- Herumschlagen der Kontaktierungsmatte (3, 4, 14, 15) um den Piezostapel (18).

13. Herstellungsverfahren nach einem der Ansprüche 8 bis 12, **dadurch gekennzeichnet, dass** der Aktorkörper (1, 18) mit den zugehörigen Anschlussstiften (3,4, 14,15) und der Kontaktierungsmatte (9, 12, 13) mit einer Vergussmasse vergossen wird.

## Claims

1. Piezo actuator having
- an actuator body (1, 18)
- two terminal pins (3, 4, 14, 15) and
- a contacting device with several electrically conductive wires (5) running next to one another connecting the actuator body (1, 18) to the terminal pins (3, 4, 14, 15),
the individual wires (5) being mechanically connected to one another and forming a contact mat (9, 12, 13),
**characterised in that**
a flexible material (8) provides the mechanical connection of the individual wires (5) so that, during subsequent operation, damage to the wires (5) in the course of longitudinal deformation of the actuator body (1, 18) is prevented.

2. Piezo actuator according to claim 1, **characterised in that** the flexible material (8) is elastic and/or vibration-damping.

3. Piezo actuator according to one of the preceding claims, **characterised in that** the individual wires (5) are encapsulated in the flexible material (8).

4. Piezo actuator according to one of the preceding claims, **characterised in that** the individual wires (5) are moulded-in or extrusion-coated with the flexible material (8) .

5. Piezo actuator according to one of the preceding claims, **characterised in that** the flexible material (8) is silicone or at least contains silicone.

6. Piezo actuator according to one of the preceding claims, **characterised in that** the wires (5) of the contact mat (9) are considerably longer than the distance to be bridged between the actuator body (1, 18) and the associated terminal pin (3, 4, 14, 15).

7. Injector for an injection system of an internal combustion engine with a piezo actuator according to one of claims 1 to 6.

8. Method for manufacturing a piezo actuator using the following steps:
- arrangement of several electrically conductive wires (5) next to one another and
- mechanical connection between the individual wires (5) to a contact mat (9, 12, 13),
**characterised in that**
the mechanical connection between the individual wires (5) is established by a flexible material (8) such that prior to any connection with a piezo stack, the wires (5) are immersed in the liquefied flexible material (8), the liquefied material (8) wetting the wires (5) and forming connection bridges between the wires (5)
- connection of the contact mat (3, 4, 14, 15) with the actuator body (1, 18) and the associated terminal pins (3, 4, 14, 15).

9. Manufacturing method according to claim 8, **characterised in that** the flexible material (8) is elastic and/or vibration-damping.

10. Manufacturing method according to one of claims 8 or 9, **characterised in that** the flexible material (8) is silicone or at least contains silicone.

11. Manufacturing method according to one of claims 8 to 10, **characterised by** the additional step of:
- winding the contact mat onto a supply roll.

12. Manufacturing method according to one of claims 8 to 11 with the additional step of:
- wrapping the contact mat (3, 4, 14, 15) around the piezo stack (18).

13. Manufacturing method according to one of claims 8 to 12, **characterised in that** the actuator body (1, 18) with the associated terminal pins (3, 4, 14, 15) and the contact mat (9, 12, 13) is encapsulated with an encapsulating material.

## Revendications

1. Actionneur piézo-électrique comprenant
- un corps (1, 18) de l'actionneur,
- deux broches de connexion (3, 4, 14, 15) et
- un moyen de formation de contacts comprenant plusieurs fils (5) conducteurs de l'électricité et s'étendant l'un à côté de l'autre, qui relient le corps (1, 18) de l'actionneur aux broches de connexion (3, 4, 14, 15),
dans lequel les différents fils (5) sont reliés mécaniquement les uns aux autres et forment une nappe de contact (9, 12, 13),
**caractérisé en ce que**
la liaison mécanique des fils (5) est formée par une matière déformable (8), afin d'éviter que, dans le fonctionnement ultérieur, les fils (5) ne soient détériorés en présence d'une variation de la longueur du corps (1, 18) de l'actionneur.

2. Actionneur piézo-électrique selon la revendication 1, **caractérisé en ce que** la matière déformable (8) est élastique et/ou antivibratoire.

3. Actionneur piézo-électrique selon une des revendications précédentes, **caractérisé en ce que** les différents fils (5) sont enrobés dans la matière déformable (8).

4. Actionneur piézo-électrique selon une des revendications précédentes, **caractérisé en ce que** les différents fils (5) sont enrobés avec la matière déformable (8) par coulée ou par surmoulage.

5. Actionneur piézo-électrique selon une des revendications précédentes, **caractérisé en ce que** la matière déformable (8) est un silicone ou que, du moins, elle contient du silicone.

6. Actionneur piézo-électrique selon une des revendications précédentes, **caractérisé en ce que** les fils (5) de la nappe de contact (9) sont beaucoup plus longs que la distance qu'il s'agit de couvrir entre le corps (1, 18) de l'actionneur et la broche de connexion correspondante (3, 4, 14, 15).

7. Injecteur pour une installation d'injection d'un moteur à combustion interne, qui comprend un actionneur piézo-électrique selon une des revendications 1 à 6.

8. Procédé de fabrication d'un actionneur piézo-électrique comprenant les étapes suivantes :
- disposer plusieurs fils conducteurs de l'électricité (5) les uns à côté des autres et
- assembler mécaniquement les différents fils (5) les uns aux autres pour former une nappe de contact (9, 12, 13),
**caractérisé en ce que** l'assemblage mécanique mutuel des fils est réalisé par une matière déformable (8) par le fait que, avant l'assemblage éventuel avec un empilement piézo-électrique, les fils (5) sont plongés dans la matière déformable liquéfiée (8), la matière liquéfiée mouillant alors les fils (5) et formant des ponts de liaison entre les fils (5).
- relier la nappe de contact (3, 4, 14, 15) au corps (1, 18) de l'actionneur et aux broches de connexion correspondantes (3, 4, 14, 15).

9. Procédé de fabrication selon la revendication 8, **caractérisé en ce que** la matière souple (8) est élastique et/ou antivibratoire.

10. Procédé de fabrication selon une des revendications 8 à 9, **caractérisé en ce que** la matière déformable (8) est du silicone ou, du moins, qu'elle contient du silicone.

11. Procédé de fabrication selon une des revendications 8 à 10,
**caractérisé par** l'étape additionnelle suivante :
- enrouler la nappe de contact sur un rouleau d'alimentation.

12. Procédé de fabrication selon une des revendications 9 à 11, comprenant l'étape additionnelle suivante :
enrouler la nappe de contact (3, 4, 14, 15) autour de la pile piézo-électrique (18).

13. Procédé de fabrication selon une des revendications 8 à 12, **caractérisé en ce qu'**on enrobe le corps (1, 18) de l'actionneur avec ses broches de connexion (3, 4, 14, 15) et la nappe de contact (9, 12, 13) avec une masse d'enrobage.
